# EUROPEAN PATENT APPLICATION

(11) **EP 4 815 651 A1**
(43) Date of publication of application: **30.09.2026**
(21) Application number: 25167208.5
(22) Date of filing: 28.03.2025
(51) Int. Cl.: H05K 7/20

(54) **ELECTRONIC CONTROL DEVICE FOR A MOTOR VEHICLE AND MOTOR VEHICLE**

(71) Applicant: Connaught Electronics Ltd., County Galway H54 Y276 (IE)
(72) Inventor: Freeman, Sophie, Tuam, H54 Y276 (IE); Trout, Shane, Tuam, H54 Y276 (IE); Sankaranarayanan, Vignesh K, 600130 Chennai, Tamil Nadu (IN)
(74) Representative: Jauregui Urbahn, Kristian

(57) **Abstract**

The invention is directed at an electronic control device (14) for a motor vehicle (34), comprising a housing (10) with a housing interior (16), a printed circuit board (18) with at least one electronic component arranged inside the housing interior (16), wherein the at least one electronic component is thermally coupled to an inner housing surface, and a cooling device, comprising a cooling structure (20), which is at least partially integrated into an outer housing surface, and a fan (22) for generating a cooling airflow (30), which is directed at the cooling structure (20). The cooling structure (20) comprises a truncated cone (28) extending from the outer housing surface and pointing towards the fan (22), wherein the truncated cone (28) comprises radially extending airflow control ribs (32).

## Description

The invention is directed at an electronic control device for a motor vehicle, comprising a housing with an upper housing part and a lower housing part, which in an assembled state confine a housing interior. The electronic control unit further comprises a printed circuit board with at least one electronic component arranged inside the housing interior, wherein the at least one electronic component is thermally coupled to an inner housing surface, in particular of the upper housing part. A cooling device of the electronic control device comprises a cooling structure, which is at least partially integrated into an outer housing surface, in particular of the upper housing part, and a fan for generating a cooling airflow. A further aspect of the invention is directed at a motor vehicle with such an electronic control device.

The functionality and computing power of computing systems for vehicles increases as more and more sophisticated applications are installed in the vehicles, for example applications for driver assistance systems or other semi-automatic or fully automatic driving functions. In particular, the computing power of electronic control devices such as electronic control units (ECUs), domain control units (DCUs) or zone control units (ZPUs) of the vehicles increases, which causes an increase in the heat dissipation of electronic components of those and other devices. Accordingly, temperatures inside housing interiors of such electronic control units or devices can rise up to 100 or 110 degrees Celsius. It is therefore known to use active or passive cooling solutions by means of a cooling fluid or cooling liquid or air for these electronic components, respectively. Along with the distribution of components on the printed circuit boards (PCBs) this requires more advanced/optimized cooling whilst maintaining envelope size requirements.

In known passive cooling systems, electronic components with a high heat dissipation are thermally conductively coupled to a heat sink, provided by the housing of the device, for example by the ECU housing. Heat is mostly conductively transferred from the electronic components to the heat sink, which in turn is heated up. In order to dissipate the heat from the heat sink, for example from the housing, the surface of the heat sink, in particular the surface of the housing, is often increased by placing heat dissipating elements on the surface, for example heat dissipating fins.

Some cooling systems additionally use fans, which may direct a cooling airflow towards the housing surface. Such cooling systems with top down fans, which blow a cooling air stream or airflow against a housing surface of an ECU housing, are for example known from CN 220653878 U, CN 115003122 A or CN 115087310 A. Those solutions do not provide a very efficient way of directing the cooling air stream or airflow towards particularly heated areas of the housing surface. The overall efficiency of those assemblies is comparably low, which is often compensated by running the fan at high speed, which leads to unpleasant noise generation.

US 2020/0348089 A1 discloses a combination of a top down fan with a number of bent heat dissipating fins, which are connected to a conical hub and extend to an edge of the heat dissipation surface. The cooling airstream can be distributed evenly across the heat dissipation surface. This may lead to an excessive cooling of some areas, while particularly hot areas may not be cooled enough.

It is an object of the present invention to increase an efficiency of a cooling system for an electronic control device of the above-described type.

The object is solved by the subject matters of the independent patent claims. Advantageous further embodiments of the invention are described by the dependent patent claims, the following description and the figures.

An aspect of the invention is directed at an electronic control device for a motor vehicle. The electronic control device may be or comprise an electronic control unit (ECU) of the above-described type. As such, the device may comprise one or more electronic components which, when in operation, may dissipate heat due to their computing power.

The electronic control device according to the invention further comprises a housing with an upper housing part and a lower housing part, which in an assembled state confine a housing interior. The upper housing part and the lower housing part may be formed as two separate parts, for example as cast components, an may comprise a metal, for example aluminum. The housing parts may also be formed as one piece. Inside the housing interior, a printed circuit board with at least one electronic component is arranged. The printed circuit board may be fastened to the housing on an inside surface of the housing, for example by screwing the printed circuit board to correspondingly formed flanges inside the housing.

The one or more electronic components which are mounted on the PCB are thermally coupled to the inner housing surface, in particular of the upper housing part. This may be done by establishing a direct physical contact between a respective electronic component and the inner housing surface. As an alternative, a thermal interface material (TIM) may be applied between the respective electronic component and the inner housing surface to enhance heat transfer. In other words, the housing, in particular the upper housing part, of the assembly according to the invention acts as a heat sink.

According to the invention, the electronic control device further comprises a cooling device. The cooling device comprises a cooling structure, which is at least partially integrated into an outer housing surface, in particular of the upper housing part. The cooling structure may be a three-dimensional structure which protrudes from the outer housing surface. Further, the cooling device comprises a fan for generating a cooling airflow, which is directed at the cooling structure. In other words, the fan is mounted in an orientation with respect to the cooling structure which allows it to blow the cooling airstream against the outer housing surface.

According to the invention, the cooling structure comprises a truncated cone extending from the outer housing surface and pointing towards the fan, wherein the truncated cone comprises radially extending airflow control ribs. In other words, the truncated cone comprises a longitudinal axis which points towards the fan and several airflow control ribs which extend radially from its lateral surface area. The ribs may be straight or curved along the lateral surface area. They may be spaced evenly around the lateral surface area. According to an embodiment, the cone may be formed as a frustum, i.e. a truncated cone with parallel base and truncation surfaces. In this case, the ribs may run at an angle of around ninety degrees with respect to either surface.

The truncated cone with its radially extending airflow control or guidance ribs receives the cooling airflow from the fan, which preferably is a top down fan. In other words, the fan may be arranged with respect to the truncated cone such that the cooling airflow is directed more or less along the longitudinal axis of the cone. At the same time, the airflow is channeled by the radially extending ribs.

Due to the cone shape of the truncated cone and the airflow control ribs, the cooling air flow is distributed along the outer housing surface at an increased efficiency compared to the known solutions. Due to the increased efficiency, the fan can be run at a comparably lower speed, which leads to reduction of the noise level, which is generated by the operation of the fan.

Further embodiments of the invention provide additional advantages.

According to an embodiment, the truncated cone is arranged in an area of the outer housing surface or of the outside surface of the housing, in particular of the upper housing part, which is opposite a surface area of the inner housing surface or opposite an inside surface area of the housing, in particular of the upper housing part, which is at an equal lateral distance from each of a plurality of electronic components which are thermally coupled to the inner housing surface. In other words, the truncated cone may be arranged in an area of the outer housing surface, which is equally spaced from each of a multitude of electronic components on the inner housing surface. In other words, the electronic control device may comprise two or more electronic components, which are arranged on the PCB and which need cooling. Each of the electronic components is thermally conductively coupled to the inner housing surface. Due to the heat transfer from each of the electronic components to the housing, also an outer housing surface opposite each of the electronic components will be heated up. In other words, the distribution of electronic components on the PCB will be mapped to a heat distribution map on the outer surface of the housing, with heat hot spots in those areas of the housing, which are thermally coupled to the electronic components, for example by a thermally conductive paste or a gap filler. In order to distribute the cooling airstream evenly to all heat hot spots, the truncated cone may be arranged centrally between the heat hot spots or with equal lateral distance to each of the hotspots. A geometry of the radially extending airflow control ribs may be adapted to the distribution of heat hot spots, to further increase the efficiency of the cooling structure.

The general idea behind the truncated cone is to direct the cooling airflow from the fan towards "hot" surface areas of the outer housing surface. The outer housing surface comprises these hot areas because it is thermally coupled on the opposite side (the inner housing surface) to the electronic components which are arranged on the PCB. Heat is transferred from the electronic components via heat conduction towards the outer housing surface. Areas of the outer housing surface which are directly opposite a respective electronic component on the inside housing surface are usually hotter than areas which are not directly opposite a respective electronic component. Like this, a heat distribution along the outer housing surface is established which may map the location of electronic components on the PCB.

Depending on the design of the PCB, the electronic components may not be evenly distributed over the PCB. This may result in an uneven distribution of hot areas along the outer housing surface. To place the truncated cone randomly on the outer housing surface could therefore not necessarily direct the cooling airflow to the areas which need the most cooling.

The thought behind the above-described embodiment is to make sure that preferably all hot areas along the outer housing surface are equally cooled by the cooling airstream. In order to achieve this, the truncated cone may be placed in an area of the outer housing surface which is at an equal lateral distance from each of a plurality of electronic components on the inner housing surface.

According to a further embodiment, the fan is arranged facing the truncated cone and is fastened to the outer housing surface, in particular of the upper housing part, such that its cooling airflow is directed top down onto the outer housing surface. In other words, the fan is sucking air in from the environment of the housing an blowing it down on the cone and the outer housing surface. This is much more efficient and has a higher thermal performance than sucking the air in from below. In other words, the fan directs the cooling airflow down on the cone and the outer housing surface opposite the electronic components on the inside of the housing. Drawing the air in from the outside through the fan onto the heated outer surface of the housing or heat sink has better thermal performance than drawing it out.

According to a further embodiment, the truncated cone provides a void for accumulating heated air inside the interior of the housing. In other words, the cone is hollow on the inside and enlarges a volume of the housing interior. In a predetermined use position, the trunk may protrude from the outer housing surface in an upward direction. Thus, heated air inside the housing interior accumulates in the void due to its reduced density compared to cooler air. In other words, the cone functions as a funnel or chimney, thus itself further increasing the cooling effect of the cooling structure.

According to a further embodiment, the truncated cone is formed as one piece with the housing, in particular with the upper housing part. Preferably, the upper housing part and the truncated cone can be formed as a cast component. Preferably, the truncated cone and the housing, in particular the upper housing part, are formed from a metal, preferably from aluminum.

According to a further embodiment, the cooling structure comprises at least one heat dissipating element formed separately from the truncated cone, wherein the airflow control ribs are designed for directing the cooling airflow from the fan towards the at least one heat dissipating element. Preferably, the at least one heat dissipating element comprises a pin or column and/or a fin, extending from the outer housing surface, in particular of the upper housing part. The at least one heat dissipating element may also be hollow and accumulate hot air from the interior of the housing. In other words, the columns and/or fins may act as a number of smaller chimneys, thus further increasing the efficiency of heat transfer from the interior of the housing to the outside. The geometry of the radially extending airflow control ribs of the truncated cone may be adapted to a distribution and/or orientation of a number of heat dissipating elements along the outer surface of the housing, which faces the fan, in order to optimize the efficiency of cooling the outer housing surface.

As described earlier, the purpose of the truncated cone with the integrated airflow control ribs is to help direct the cooling airflow into different directions. In other words, the cone shape pushes or forces the air out in different directions. The ribs on the cone itself provide additional guidance to direct airflow in different directions. The additional heat dissipating element(s) may cause turbulent flow along the outside surface of the housing, which further increases the cooling effect. As the heat dissipating element(s) are formed separately from the truncated cone, the can be freely and adequately distributed over the outer surface of the housing. Especially the pins can be positioned more flexibly on top of especially hot components inside the housing, thus covering the abovementioned heat hot spots.

According to an embodiment, the fin-shaped heat dissipating elements extend radially outward towards an edge of the outer housing surface, in particular of the upper housing part. The fins may form airflow channels for directing the cooling airstream to heat hot spots efficiently.

According to an embodiment, the at least one heat dissipating element is arranged in an area of the outer housing surface, in particular of the upper housing part, which is opposite a surface area of the inner housing surface, in particular of the upper housing part, which is thermally coupled to the at least one electronic component. The heat dissipating element(s) may be centered to the fan to optimize cooling for each hot component inside the housing.

According to an embodiment, an air gap is arranged between the radially extending airflow control ribs and the at least one heat dissipating element. The air gap may further increase the turbulent component of the cooling airflow, thus further increasing the cooling efficiency.

Preferably, the at least one heat dissipating element is formed as one piece with the housing, in particular with the upper housing part. The at least one heat dissipating element and the housing, in particular the upper housing part, may be formed from a metal, preferably from aluminum. The housing, in particular the upper housing part, may be formed as one piece with the truncated cone and the at least one heat dissipating element. For example, the housing may be formed as a cast component with the truncated cone including the radially extending ribs and with the at least one heat dissipating element.

Preferably, the electronic control device is a control device of the motor vehicle, which is designed to control at least one vehicle function of the motor vehicle. In other words, the electronic device is or comprises a control device for controlling at least one vehicle function of the motor vehicle, in particular an electronic control unit (ECU), which can preferably be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the electronic assembly according to the invention can be a main controller of the motor vehicle. Alternatively, the electronic assembly according to the invention may be a zonal controller of the motor vehicle. Accordingly, the cooling device according to the invention can be provided for cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the cooling device.

A further aspect of the invention relates to a motor vehicle comprising an electronic device according to the invention.

Further embodiments of the motor vehicle according to the invention follow directly from the various embodiments of the electronic control device according to the invention and vice versa. In particular, individual features and corresponding explanations as well as advantages relating to the various implementations of the electronic control device according to the invention can be transferred analogously to implementations of the motor vehicle according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

Embodiments of the invention are described below. In the figures:
- Fig. 1: Shows a schematic view of an upper housing part of an electronic control device according to an embodiment of the invention, comprising a cooling structure with a top down fan;
- Fig. 2: Shows a schematic detailed section view of the upper housing part according to Fig. 1;
- Fig. 3: Shows a schematic cross sectional view of the upper housing part according to Figs. 1 and 2, indicating a direction of airflow;
- Fig. 4: Shows a schematic view of the upper housing part according to the previous figures without the fan;
- Fig. 5: Shows a schematic top down view of the upper housing part according to Fig. 4; and
- Fig. 6: Shows a schematic view of a motor vehicle with an electronic control device according to an embodiment of the invention.

The embodiments explained below are preferred embodiments of the invention. In the embodiments, the described components of the embodiments each represent individual features of the invention which are to be considered independently of each other, which also further form the invention independently of each other and are thus also to be regarded as part of the invention individually or in a combination other than that shown.

Furthermore, the embodiment described can also be supplemented by other features of the invention already described.

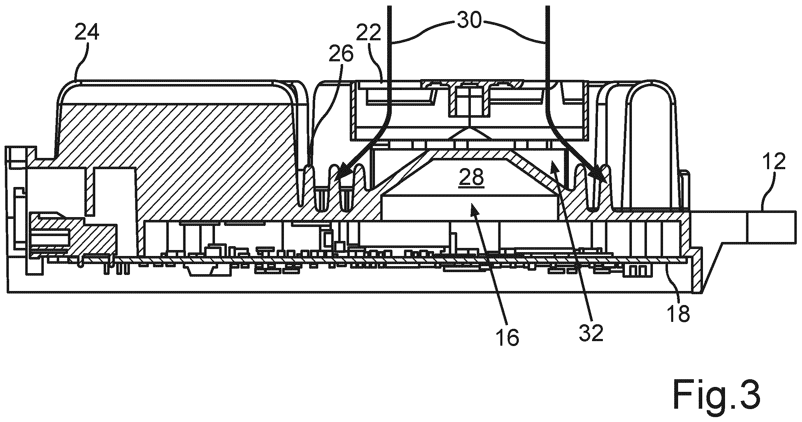

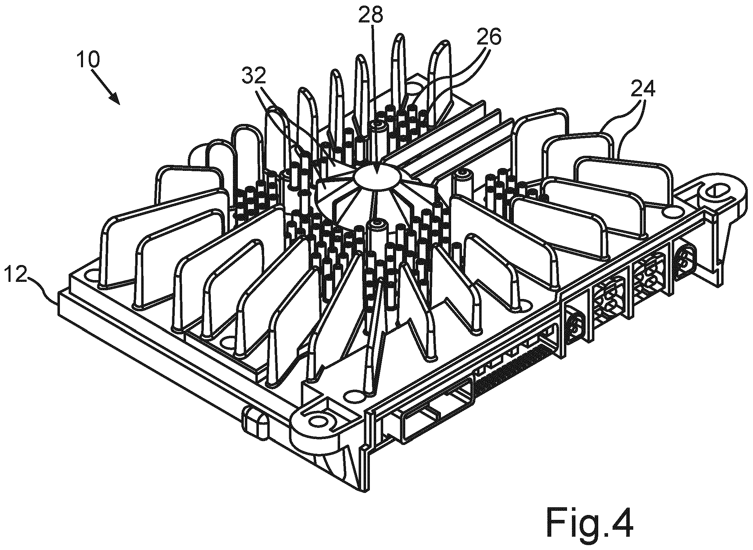

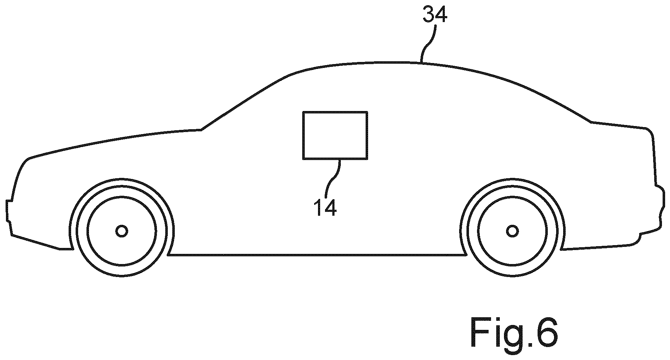

Figs. 1 to 5 show schematic views of a housing 10, in particular of an upper housing part 12 of a housing 10, of an electronic control device 14 (for the device 14, reference is made to Fig. 6). The upper housing part 12 as shown in Figs. 1 to 5 is designed to be fastened to a lower housing part (not shown), to form the housing 10 with a housing interior 16 (for the interior 16, reference is made to Fig. 3). In other words, in an assembled state, the upper housing part 12 and the lower housing part confine the housing interior 16.

The upper housing part 12 and the lower housing part may be formed as cast components, for example from aluminum or another metal with comparable heat conducting properties. The housing parts may be screwed together, after assembly of several components inside the housing interior 16.

In the housing interior 16, a printed circuit board 18 (see Fig. 3) with at least one electronic component (not shown) may be arranged. The operation of the at least one electronic component may lead to thermal dissipation of power and heating up of the air inside the housing interior 16. Therefore, efficient cooling of the housing 10 is required.

In order to transfer heat from the at least one electronic component, it may be thermally coupled to an inner surface of the upper housing part 12. The coupling may be improved by applying a thermal interface material between the at least one electronic component and the inner surface. Thus, heat from the at least one electronic component is transferred to the upper housing part 12, which itself will be heated up at least in those areas, which are thermally coupled to the electronic component(s). In other words, the heat distribution along the outer surface of the upper housing part 12 may mirror the distribution of electronic component(s) on the PCB 18.

For efficient cooling of the housing 10, the upper housing part 12 according to Figs. 1 to 5 comprises a cooling device with a cooling structure 20 and a fan 22. The cooling structure 20 may be at least partially integrated into the upper housing part 12. It may, for example, be formed as one piece with the upper housing part 12. In other words, the upper housing part 12 may be cast with the cooling structure 20, which may comprise several heat dissipating elements like fins 24 and pins or columns 26. The heat dissipating elements 24, 26 protrude or extend from the outer surface of the upper housing part 12.

The protruding heat dissipating elements 24, 26 enhance the efficient cooling of the housing 10, especially in those areas of the upper housing part 12, which are thermally coupled to the electronic component(s) on the inside ("hot spots"). The outer surface of the upper housing part 12 is enlarged by the heat dissipating elements 24, 26, which allows increased heat flow from the surface towards an environment of the housing 10.

In addition to the heat dissipating elements 24, 26, the cooling structure comprises a truncated cone 28, which protrudes from the outer housing surface in essentially the same direction as the heat dissipating elements 24, 26. The truncated cone 28 points towards the fan 22, which may be a top down blowing fan 22. In other words, the cone 28 may be arranged with respect to the fan 22 or vice versa such that an airflow direction 30 (see Fig. 3) of an airflow which is generated by the fan 22 is directed at the top of the truncated cone 28 and may be distributed towards the heat dissipating elements 24, 26 by the inclined lateral surface of the truncated cone 28.

As may be seen from the example shown in Fig. 3, the cone 28 may be hollow on the inside, i.e. on the side which faces the housing interior 16. This leads to a chimney effect, i.e. to a collection of heated up air inside the cone 28, which is efficiently cooled-off on the outside surface by the cooling airflow 30 which is directed at it.

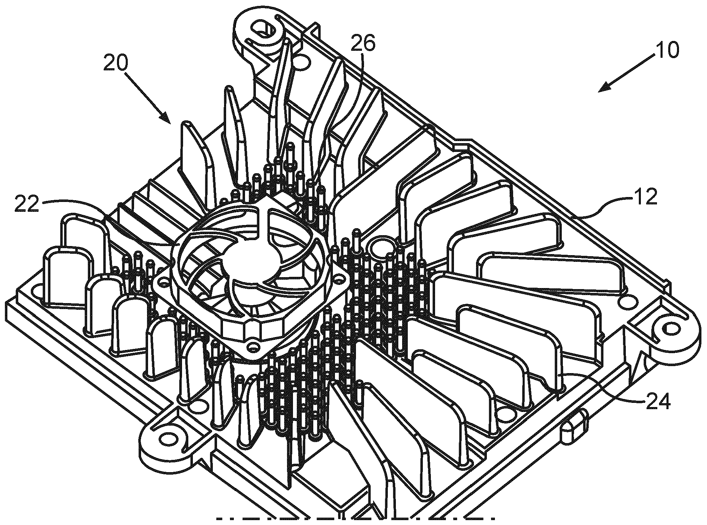

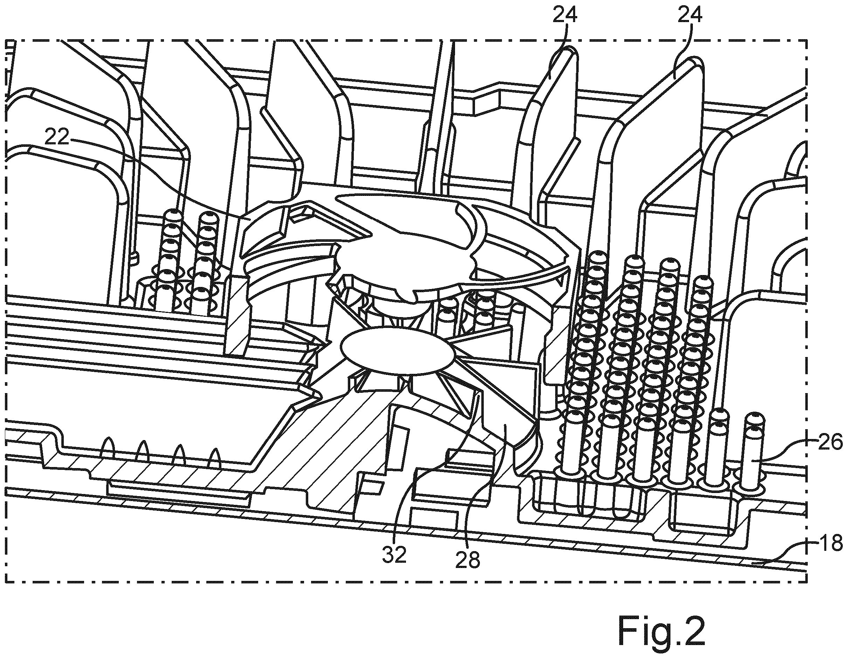

The truncated cone 28 may further comprise radially extending airflow control ribs 32 (see for example Figs. 2 and 3). The airflow control ribs 32 may be evenly spaced along the flanks or lateral surface of the truncated cone 28, as shown in the figures. The ribs 32 may also be spaced differently, in particular irregularly, such that the enhance the cooling airflow 30 in hot spot areas along the outer surface of the upper housing part 12.

The ribs 32 and the heat dissipating elements 24, 26 may not be connected. In other words, there may be a gap or an air gap between the radially extending airflow control ribs 32 and the heat dissipating elements 24, 26. This may increase the amount of turbulent flow in the airflow 30, which leads to a better thermal performance, i.e. more efficient cooling of the outer surface of the upper housing part 12.

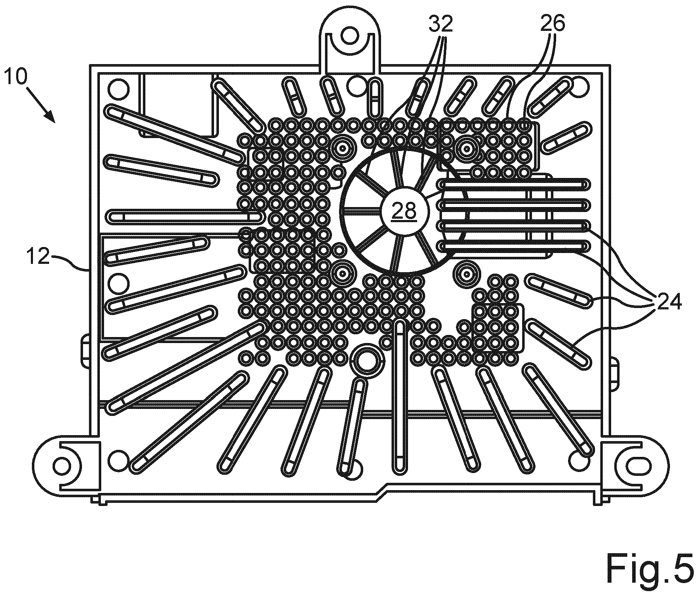

The described arrangement is for example shown in Fig. 5 which displays a schematic top down view on the upper housing part 12 without the fan 22 for clarity. The design of the cooling structure with the truncated cone 28 and the heat dissipating elements 24, 26 can be chosen freely and depending on the heat distribution along the outer surface of the upper housing part 12. In the shown example, the truncated cone 28 is placed off-center, slightly shifted to the upper right corner of the upper housing part 12. Around about three-quarters of the circular base of the truncated cone 28, columns or pins 26 are arranged next to the truncated cone 28. Those pins 26 may increase the turbulent flow of the airstream 30 in this area for cooling it down efficiently. Adjacent to the pins 26, a number of fins 24 are extending radially outward towards an edge of the upper housing part 12. The fins 24 may guide the airflow 30 out and away from the truncated cone 28.

The exemplary geometry of fins 24, pins 26 and the truncated cone 28 with its ribs 32 may optimize cooling for each electronic hot component inside the housing 10.

Fig. 6 shows a schematic view of a motor vehicle 34 with an electronic control device 14, comprising a housing 10 with an upper housing part 12, in particular designed as described above with relation to Figs. 1 to 5.

The invention is directed at a heatsink for an electronic control device 14, comprising a cooling structure to direct airflow 30 using a fan 22, preferably a top down fan 22.

Electronic components in an electronic control device 14, in particular for controlling at least one vehicle function of a motor vehicle 34, are using higher computing power over a smaller area provided by the suppliers. Along with the distribution of components on the PCB 18 of the electronic control device 14 this requires more advanced and/or optimized cooling whilst maintaining envelope size requirements.

Using a fan 22, in particular a top down fan 22, allows a lager frame and increased airflow in the design to cool components. The raised platform and draft (i.e. the truncated cone 28) in the heatsink or the upper housing part 12 directly under the fan motor will direct the airflow 30 from the fan 22 over the components at increased efficiency.

Better fan efficiency could also result in fan running at lower speed and decreasing the noise levels in the electronic control device 14.

Airflow 30 directed from the fan 22 may go into pins 26 and/or fins 24 which helps heat transfer from hotspot components. When several hot components on the PCB board 18 are spaced out and require to be air cooled this heatsink guide (i.e. the truncated cone 28 with the integrated radially extending airflow control ribs 32) will allow airflow 30 to be directed to key areas from a single fan 22.

Overall, the examples show, how an efficiency of passive cooling systems for electronic control devices can be increased.

## Claims

1. Electronic control device (14) for a motor vehicle (34), comprising
- a housing (10) with an upper housing part (12) and a lower housing part, which in an assembled state confine a housing interior (16),
- a printed circuit board (18) with at least one electronic component arranged inside the housing interior (16), wherein the at least one electronic component is thermally coupled to an inner housing surface, in particular of the upper housing part (12), and
- a cooling device, comprising a cooling structure (20), which is at least partially integrated into an outer housing surface, in particular of the upper housing part (12), and a fan (22) for generating a cooling airflow (30), which is directed at the cooling structure (20),
**characterized in that**
the cooling structure (20) comprises
- a truncated cone (28) extending from the outer housing surface and pointing towards the fan (22), wherein the truncated cone (28) comprises radially extending airflow control ribs (32).

2. Electronic control device (14) according to claim 1, wherein the truncated cone (28) is arranged in an area of the outer housing surface, in particular of the upper housing part (12), which is opposite a surface area of the inner housing surface, in particular of the upper housing part (12), which is at an equal lateral distance from each of a plurality of electronic components which are thermally coupled to the inner housing surface.

3. Electronic control device (14) according to any of the preceding claims, wherein the fan (22) is arranged facing the truncated cone (28) and is fastened to the outer housing surface, in particular of the upper housing part (12), such that its cooling airflow (30) is directed top down onto the outer housing surface with the truncated cone (28).

4. Electronic control device (14) according to any of the preceding claims, wherein the truncated cone (28) provides a void for accumulating heated air inside the interior of the housing (10).

5. Electronic control device (14) according to any of the preceding claims, wherein the truncated cone (28) is formed as one piece with the housing (10), in particular with the upper housing part (12).

6. Electronic control device (14) according to claim 5, wherein the truncated cone (28) and the housing (10), in particular the upper housing part (12), are formed from a metal, preferably from aluminum.

7. Electronic control device (14) according to any of the preceding claims, wherein the cooling structure (20) comprises at least one heat dissipating element (24, 26) formed separately from the truncated cone (28), wherein the airflow control ribs (32) are designed for directing the cooling airflow (30) from the fan (22) towards the at least one heat dissipating element (24, 26).

8. Electronic control device (14) according to claim 7, wherein the at least one heat dissipating element (24, 26) comprises a pin (26) and/or a fin (24), extending from the outer housing surface, in particular of the upper housing part (12).

9. Electronic control device (14) according to claim 8, wherein the fin-shaped heat dissipating elements (24) extend radially outward towards an edge of the outer housing surface, in particular of the upper housing part (12).

10. Electronic control device (14) according to any of claims 7 to 9, wherein the at least one heat dissipating element (24, 26) is arranged in an area of the outer housing surface, in particular of the upper housing part (12), which is opposite a surface area of the inner housing surface, in particular of the upper housing part (12), which is thermally coupled to the at least one electronic component.

11. Electronic control device (14) according to any of claims 7 to 10, wherein an air gap is arranged between the radially extending airflow control ribs (32) and the at least one heat dissipating element (24, 26).

12. Electronic control device (14), according to any of claims 7 to 11, wherein the at least one heat dissipating element (24, 26) is formed as one piece with the housing (10), in particular with the upper housing part (12).

13. Electronic control device (14) according to claim 12, wherein the at least one heat dissipating element (24, 26) and the housing (10), in particular the upper housing part (12), are formed from a metal, preferably from aluminum.

14. Electronic control device (14) according to any of the preceding claims, wherein the electronic control device (14) is a control device of the motor vehicle (34), which is designed to control at least one vehicle function of the motor vehicle (34).

15. Motor vehicle (34) with an electronic control device (14) according to any of the preceding claims.
